# EUROPÄISCHE PATENTANMELDUNG

(11) **EP 0 673 064 A1**
(43) Veröffentlichungstag der Anmeldung: **20.09.1995**
(21) Anmeldenummer: 95103438.8
(22) Anmeldetag: 09.03.1995
(51) Int. Cl.: H01L 23/40

(54) **Vorrichtung zum Kühlen von elektronischen Bauelementen**

(30) Priorität: 16.03.1994 DE 4409015
(71) Anmelder: Siemens Nixdorf Informationssysteme AG, D-33106 Paderborn (DE)
(72) Erfinder: Bachl, Johann, Dipl.-Ing., D-80638 München (DE)
(74) Vertreter: Fuchs, Franz-Josef, Dr.-Ing.

(57) **Zusammenfassung**

Zum Kühlen von elektronischen Bauelementen (2) auf einer Trägerplatte (1) wird eine Haltevorrichtung für Kühlkörper (4) vorgeschlagen, durch die die Kühlkörper (4) an die zu kühlenden Bauelemente (2) ohne direkte Befestigung an die zu kühlenden Bauelemente federnd angedrückt werden. Um eine Verbesserung des Wärmeübergangs zwischen einem zu kühlenden Bauelement (2) und einem Kühlkörper (4) bei Erwärmung des zu kühlenden Bauelements (2) zu erreichen, wird die federnde Wirkung des Kühlkörpers (4) durch Bi-Metallelemente erzeugt. Durch die Bi-Metallelemente wird der Kühlkörper (4) bei Erwärmung des zu kühlenden Bauelements (2) stärker an das zu kühlende Bauelement (2) angedrückt.

## Beschreibung

Die Erfindung betrifft eine Vorrichtung zum Kühlen von elektronischen Bauelementen gemäß dem Oberbegriff des Anspruchs 1.

Zum Betreiben von elektronischen Baugruppen muß die von den zugehörigen, auf einer Trägerplatte angeordneten elektronischen Bauelementen erzeugte Verlustwärme über ein Kühlsystem abgeführt werden. Dies ist insbesondere bei der Anwendung von in ECL-Technik gefertigten elektronischen Bauelementen notwendig.

Es ist bekannt, Kühlkörper durch Kleben oder mechanische Verfahren direkt auf den elektronischen Bauelementen zu befestigen. Hierfür ist ein großer Arbeitsaufwand notwendig.

Die Anschlüsse der elektronischen Bauelemente werden immer feiner und daher immer empfindlicher gegenüber mechanischen Belastungen. Demgegenüber werden die Kühlkörper immer größer, damit sie die infolge der immer höheren Integrationsdichte in den elektronischen Bauelementen verursachte erhöhte Verlustwärme abführen können.

Aus der DE 41 28 936 A1 ein federndes Halteelement für Kühlkörper bekannt, durch das ein Kühlkörper ohne direkte Befestigung auf einem zu kühlenden Bauelement federnd an das zu kühlende Bauelement angedrückt wird. Eine Belastung für die Anschlüsse der elektronischen Bauelemente ist daher nurmehr durch eine Andruckkraft des Kühlkörpers und eventuell durch eine seitliche Schubkraft durch eine Reibung verursacht.

Ein Nachteil des bekannten Halteelements für Kühlkörper ist, daß der bestehende Wärmeübergang zwischen dem zu kühlenden Bauelement und dem Kühlkörper bei erhöhter Erhitzung des zu kühlenden Bauelements trotz höherem Bedarf an Wärmeableitung für das zu kühlende Bauelement eine höhere Wärmeübertragungsleistung nicht gegeben ist, da an der Wärmeübergangsstelle nichts verbessert wird.

Aufgabe der Erfindung ist es, eine Vorrichtung zum Kühlen von elektronischen Bauelementen der eingangs genannten Art anzugeben, bei der in Abhängigkeit vom Wärmeableitungsbedarf eines zu kühlenden Bauelements eine Verbesserung der Wärmeableitungsleistung gegeben ist.

Diese Aufgabe wird durch die im kennzeichnenden Teil des Anspruchs 1 angegebenen Merkmale gelöst.

Durch Verwenden von Bi-Metallelementen für die Erzeugung der federnden Wirkung des Kühlkörpers wird bei Erwärmung des zu kühlenden Bauelements eine federnde Wirkung verstärkt weg von der Halteplatte erzeugt. Dadurch wird der Kühlkörper stärker an das zu kühlende Bauelement gedrückt. Der Wärmeübergang zwischen dem zu kühlenden Bauelement wird verbessert, wodurch eine verbesserte Wärmeableitung ermöglicht wird.

Nachfolgend wird ein Ausführungsbeispiel der Erfindung anhand einer Zeichnung näher erläutert.

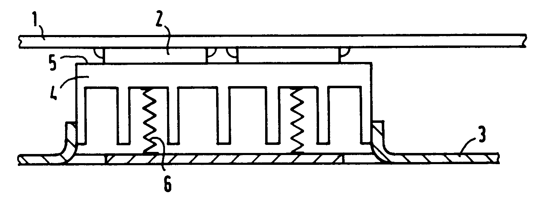

In der Figur ist eine Trägerplatte 1 gezeigt, die mit elektronischen Bauelementen 2 bestückt ist. Die Trägerplatte 1 mit den elektronischen Bauelementen 2 könnte Teil einer elektronischen Baugruppe, beispielsweise einer Rechnereinheit sein. Im Bereich und auf Seiten der elektronischen Bauelemente 2 der Trägerplatte 1 ist eine Halteplatte 3 vorgesehen. Die Halteplatte 3 dient zum Halten von Kühlkörpern 4. In der Figur ist nur einer davon angegeben. Dies ist aber nur eine Prinzipdarstellung. Weitere Kühlkörper 3 könnten vorgesehen sein.

Die Halteplatte 3 ist mit einem fest vorgegebenen Abstand parallel zur Trägerplatte 1 angeordnet. Zwischen den zu kühlenden elektronischen Bauelementen 2 der Trägerplatte 1 und der Halteplatte 3 ist einer der oben bereits angesprochenen Kühlkörper 4 angeordnet. Der Kühlkörper 4 weist eine plane Auflagenfläche 5 zum Aufliegen auf die zu kühlenden elektronischen Bauelemente 2 auf. In diesem Sinn ist der Kühlkörper 4 in der Weise ausgerichtet angeordnet, daß die Auflagenfläche 5 des Kühlkörpers 4 hin zu den zu kühlenden elektronischen Bauelementen 2 weist.

Die Halteplatte 3 hält den Kühlkörper 4 mit einer Bewegungsfreiheit senkrecht zur Halteplatte 3 und darüberhinaus mit einer federnden Wirkung weg von der Halteplatte 3. Die Halteplatte 3 sichert den Kühlkörper 4 gegen seitliches Verrutschen, durch formschlüssige Einbettung. Bei federnden Bauelementeanschlüssen, zum Beispiel sogenannte TAB, kann das federnde Element auch zwischen Bauelement 2 und Trägerplatte 1 untergebracht werden, womit man einen entsprechend großen Kühlkörper 4 vorsehen könnte.

Der Abstand der Halteplatte 3 von der Trägerplatte 1 ist derart gewählt, daß der Kühlkörper 4 entgegen der federnden Wirkung durch die zu kühlenden elektronischen Bauelemente 2 zurückgedrückt gehalten ist. Hierdurch ergibt sich ein stetiger gefederter Andruck des Kühlkörpers 4 an die zu kühlenden elektronischen Bauelemente 2. Ein Wärmeübergangskontakt ist hergestellt, ohne daß die zu kühlenden elektronischen Bauelemente 2 die Last des Kühlkörpers 4 tragen müssen. Seitliche Ausgleichsbewegungen sind möglich, wenn sich die verschiedenen zu kühlenden elektronischen Bauelemente 2 wegen einem unterschiedlichen Aufheizen unterschiedlich ausdehnen.

Die federnde Wirkung des Kühlkörpers 4 kann beispielsweise durch Druckfedern 6 hergestellt sein. Desweiteren könnte die federnde Wirkung durch Bi-Metallelemente hergestellt sein, die eine Wirkung aufweisen, entsprechend der Wirkung der Druckelemente 6 mit dem Unterschied, daß sie bei einer Erwärmung einen erhöhten Federdruck ausüben.

## Patentansprüche

1. Vorrichtung zum Kühlen von elektronischen Bauelementen (2), die auf einer Trägerplatte (1) angeordnet sind, mittels Kühlkörper (4), für den im Bereich und auf Seiten der zu kühlenden elektronischen Bauelemente (2) der Trägerplatte (1) eine Halteplatte (3) vorgesehen ist, die mit einem fest vorgegebenen Abstand parallel zur Trägerplatte (1) angeordnet ist, und der mit einer planen Auflagefläche (5) zum Aufliegen auf die zu kühlenden elektronischen Bauelemente (2) zwischen den zu kühlenden elektronischen Bauelementen (2) und der Halteplatte (3) mit einer Ausrichtung der Auflagefläche (5) hin zu den zu kühlenden elektronischen Bauelemente (2) angeordnet ist derart, daß durch die Halteplatte (3) für den Kühlkörper (4) eine Halterung mit einer Bewegungsfreiheit senkrecht zur Halteplatte (3) und einer federnden Wirkung weg von der Halteplatte (3) gegeben ist, **dadurch gekennzeichnet,**
daß die federnde Wirkung durch Bi-Metallelemente erzeugt ist, die bei einer Erwärmung eine federnde Wirkung verstärkt weg von der Halteplatte (3) aufweisen.
